(19) Europäisches Patentamt
European Patent Office
Office européen des brevets

(11) **EP 1 801 844 B1**

(12) **EUROPÄISCHE PATENTSCHRIFT**

(45) Veröffentlichungstag und Bekanntmachung des Hinweises auf die Patenterteilung:
**14.03.2012 Patentblatt 2012/11**

(51) Int Cl.:
***H01J 37/304*** *(2006.01)*  ***H01J 37/28*** *(2006.01)*

(21) Anmeldenummer: **06021534.0**

(22) Anmeldetag: **13.10.2006**

(54) **Verfahren und Vorrichtung zur Abstandsmessung**

Method and apparatus for distance measurement

Procédé et dispositif pour mesurer de la distance

(84) Benannte Vertragsstaaten:
**CZ DE GB NL**

(30) Priorität: **21.12.2005 DE 102005061687**

(43) Veröffentlichungstag der Anmeldung:
**27.06.2007 Patentblatt 2007/26**

(73) Patentinhaber: **Carl Zeiss NTS GmbH**
**73447 Oberkochen (DE)**

(72) Erfinder:
• **Walter, Gero**
**73463 Westhausen (DE)**
• **Härle, Rainer**
**89522 Heidenheim (DE)**

(74) Vertreter: **Patentanwälte Freischem**
**Salierring 47-53**
**50677 Köln (DE)**

(56) Entgegenhaltungen:
**EP-A- 1 081 741    JP-A- 7 245 075**
**US-A- 4 134 014    US-A- 4 978 856**
**US-A- 5 216 235**

EP 1 801 844 B1

**Beschreibung**

Die Erfindung betrifft ein Verfahren und eine Vorrichtung zur Bestimmung des Abstands einer zu untersuchenden Probe von einem Referenzpunkt, insbesondere in einem Teilchenstrahlgerät. Das erfindungsgemäße Verfahren und die erfindungsgemäße Vorrichtung sind auch zur Bestimmung der Topographie einer Probe einsetzbar.

Bereits seit langem sind Teilchenstrahlgeräte in Form von Elektronenstrahlgeräten, insbesondere Rasterelektronenmikroskope, bekannt. Diese werden zur Untersuchung von Oberflächen eines Objekts (Probe) verwendet. Hierzu wird bei einem Rasterelektronenmikroskop ein Elektronenstrahl (nachfolgend Primärelektronenstrahl genannt) mittels eines Strahlerzeugers erzeugt und durch eine Objektivlinse auf das zu untersuchende Objekt fokussiert, welches auf einem Probenträger angeordnet ist, mit dessen Hilfe die Position des Objekts einstellbar ist. Mittels einer Ablenkeinrichtung wird der Primärelektronenstrahl rasterförmig über die Oberfläche des zu untersuchenden Objektes geführt. Die Elektronen des Primärelektronenstrahls treten dabei in Wechselwirkung mit dem Objekt. Als Folge der Wechselwirkung werden insbesondere Elektronen aus der Objektoberfläche emittiert (sogenannte Sekundärelektronen) oder Elektronen des Primärelektronenstrahls zurückgestreut (sogenannte Rückstreuelektronen). Die Rückstreuelektronen weisen dabei eine Energie im Bereich von 50 eV bis zur Energie der Elektronen des Primärelektronenstrahls am Objekt auf, während die Sekundärelektronen eine Energie kleiner als 50 eV aufweisen. Sekundär- und Rückstreuelektronen bilden den nachfolgend so genannten Sekundärstrahl und werden mit einem Detektor detektiert. Das hierdurch erzeugte Detektorsignal wird zur Bilderzeugung verwendet.

Elektronenstrahlgeräte weisen eine hohe Ortsauflösung auf, die durch einen sehr geringen Durchmesser des Primärelektronenstrahls in der Ebene des Objektes erzielt wird. Die Auflösung ist um so besser, je näher das Objekt an der Objektivlinse des Elektronenstrahlgerätes angeordnet ist. Es ist auch besonders wichtig, den Primärelektronenstrahl genau auf das Objekt zu fokussieren. Es ist daher erforderlich, die Position des Objekts und somit auch den Abstand des Objekts zur Objektivlinse genau zu bestimmen.

Wie oben bereits kurz erwähnt, ist es bei vielen Elektronenstrahlgeräten auch üblich, Probenträger zur Aufnahme der zu untersuchenden Probe zu verwenden, mit deren Hilfe sich die Position der Probe in dem Elektronenstrahlgerät einstellen läßt. Dabei ist die Position sowohl in einer X-Y-Ebene, die senkrecht zur Strahlachse des jeweiligen Elektronenstrahlgeräts angeordnet ist, als auch in Z-Richtung einstellbar, die der Strahlachse des jeweiligen Elektronenstrahlgeräts entspricht. Bei einigen Probenträgern ist auch eine Verkippung der Probe in Bezug auf die Strahlachse vorgesehen, so daß die Strahlachse des Elektronenstrahlgeräts nicht senkrecht auf der Oberfläche der Probe steht. Allerdings ist es bei vielen Untersuchungen gerade von planen Proben, beispielsweise Wafern, gewünscht, daß die Oberfläche der Probe stets senkrecht zur Strahlachse angeordnet ist.

Aus der US 4,978,856 ist ein Autofokussystem für ein Rasterelektronenmikroskop bekannt, das eine Objektlinse zur Fokussierung des Elektronenstrahls auf ein Objekt aufweist. Ein der Objektivlinse zugeführter Anregungsstrom wird mit einem periodischen Signal moduliert. Ferner wird der Anregungsstrom in Abhängigkeit eines Wobbelsignals gewobbelt. Die aus der zu untersuchenden Probe emittierten bzw. zurückgestreuten Teilchen werden detektiert. Das resultierende Signal wird integriert, wodurch zahlreiche Meßpeaks, die einen gewissen Wert aufweisen, ermittelt werden. Durch ein Näherungsverfahren wird ein Wert bestimmt, mit dessen Hilfe der Anregungsstrom der Objektivlinse zur Fokussierung des Elektronenstrahls auf der Probe berechnet wird. Dieser berechnete Anregungsstrom wird der Objektivlinse zugeführt. Bei dem bekannten Verfahren bzw. bei der bekannten Vorrichtung ist allerdings keine Positions- oder Abstandbestimmung der Probe möglich.

Aus der US 5,216,235 ist ein Autofokussystem für ein Rasterelektronenmikroskop bekannt, das zusätzlich zu einer Teilchenstrahlsäule, die einen Strahlerzeuger und eine Objektivlinse aufweist, mit einem optischen System zur Bestimmung des Abstands einer Probe zur Objektivlinse versehen ist. Das optische System umfaßt einen Laser, dessen Strahlen auf die Probe geleitet werden. Allerdings ist dieses bekannte Autofokussystem aufgrund des zusätzlichen optischen Systems sehr aufwendig. Zudem muß die zu untersuchende Probe gute optische Eigenschaften aufweisen, um eine genaue Bestimmung des Abstandes zu ermöglichen. Gute optische Eigenschaften sind aber nicht bei jeder zu untersuchenden Probe gewährleistet. Auch kann es aufgrund von Strukturen auf der Probe zu Beugungseffekten kommen, die zu Meßfehlern führen.

Aus der EP 1 081 741 A2 ist ein Verfahren zum Fokussieren eines Teilchenstrahls bekannt. Bei dem bekannten Verfahren wird eine Fokussierung mittels eines Probenträgers In Z-Richtung durchgeführt. Eine Korrektur, beispielsweise aufgrund von Ladungen, wird durch Änderung der Energie des Teilchenstrahls durchgeführt. Ferner ist es aus dieser Druckschrift bekannt, dass ein Primärteilchenstrahl in Form eines Elektronenstrahls auf eine Probe geführt wird. Beim Auftreffen des Primärteilchenstrahls auf der Probe entsteht ein aus Teilchen bestehender Sekundärteilchenstrahl, der von der Probe weggeführt wird. Auch werden Sekundärteilchen mit einem Detektor delektiert.

Der Erfindung liegt demnach die Aufgabe zugrunde, ein Verfahren und eine Vorrichtung zur Bestimmung des Abstands einer Probe zu einem Referenzpunkt anzugeben, die unabhängig von der Art der Probe arbeiten, wobei das Verfahren einfach durchzuführen sowie die Vorrichtung einfach ausgestaltet ist.

Erfindungsgemäß wird diese Aufgabe durch ein Verfahren mit den Merkmalen das Anspruchs 1 gelöst. Eine erfindungagemäße Vorrichtung bzw. ein erfadungsgemäßes Teilchenstrahlgerät mit dieser Vorrichtung ist durch die Merkmale des Anspruchs 11 bzw. 18 charakterisiert.

Bei dem erfindungsgemäßen Verfahren zur Bestimmung eines Abstands einer zu untersuchenden Probe von mindestens einem Referenzpunkt wird einem ersten Potential einer Probe oder auf ein Hochspannungspotential ein erstes Signal aufmoduliert. Bei Zuführung eines Primärteilchenstrahls auf die Probe wird bei einem Auftreffen des Primärteilchenstrahls auf die Probe ein aus Teilchen bestehender Sekundärteilchenstrahl erzeugt, der von der Probe weggeführt wird und dessen Teilchen eine Energie mit dem aufmodulierten Signal aufweisen. Die Teilchen des Sekundärteilchenstrahls sowie das der Energie der Teilchen aufmodulierte Signal werden detektiert. Durch Vergleichen des detektierten aufmodulierten Signals mit einem Referenzsignal wird mittels einer Relation zwischen dem Referenzsignal und dem aufmodulierten Signal der Abstand der Probe zu dem Referenzpunkt bestimmt.

Durch das erfindungsgemäße Verfahren ist es auf einfache Weise möglich, den Abstand der Probe zu einem Referenzpunkt, insbesondere einem Detektor, genau zu bestimmen. Da in einem Teilchenstrahlgerät die Position des Detektors gegenüber einer Objektivlinse festgelegt ist, ist auf diese Weise auch der Abstand zwischen der Probe und der Objektivlinse genau bestimmbar und somit auch einstellbar. Auf diese Weise ist es einfach möglich, den Primärteilchenstrahl auf der Probe ausreichend zu fokussieren. Nach einer entsprechenden Kalibrierung liefert das Verfahren Messungen von besonders guter Genauigkeit.

Die Teilchen des Sekundärteilchenstrahls sind als geladene Teilchen ausgebildet. Vorzugweise werden für die Abstandbestimmung hauptsächlich vom Objekt rückgestreute Elektronen (Rückstreuelektronen) verwendet, die am Referenzpunkt mit einem Detektor detektiert werden. Der Detektor ist somit ein für Rückstreuelektronen sensitiver Detektor.

Ferner ergibt sich aufgrund der Aufmodulation am Ort der Probe eine Energiedifferenz der Rückstreuelektronen am Ort des Detektors. Insofern weist der zu verwendende Detektor vorzugsweise eine von der Elektronenenergie abhängige Sensitivität auf, so daß das zweite Potential der Rückstreuelektronen, welches das aufmodulierte Signal aufweist, sich im durch den Detektor erzeugten Signal auch wiederspiegelt.

Das erfindungsgemäße Verfahren weist gegenüber den aus dem Stand der Technik bekannten Verfahren auch den Vorteil auf, daß es sehr einfach durchführbar ist. Denn bei dem erfindungsgemäßen Verfahren wird kein zusätzliches System zur Abstandsbestimmung benötigt. Vielmehr wird der Abstand mittels bereits vorhandener Mittel bestimmt. So weist beispielsweise ein Elektronenstrahlgerät einen Primärteilchenstrahl, einen Sekundärteilchenstrahl sowie Mittel zur Detektion auf.

Diese werden sowohl zur Durchführung des erfindungsgemäßen Verfahrens als auch zur Bildgebung verwendet. Meist wird in einem Elektronenstrahlgerät auch der Probenstrom gemessen, wozu zwischen der Probe und einem Messgerät eine elektrische Verbindung besteht. Diese elektrische Verbindung ist auch zur Modulation einsetzbar, so daß keine weiteren aufwendigen Komponenten verbaut werden müssen.

Ferner erfordert das erfindungsgemäße Verfahren im Vergleich zu bisher bekannten optischen Verfahren zur Abstandsbestimmung auch keine Anforderungen an optische Eigenschaften der zu untersuchenden Probe. Denn bei dem vorliegenden Verfahren wird praktisch mit bereits vorhandenen Mitteln, nämlich insbesondere dem Primärteilchenstrahl und dem Sekundärteilchenstrahl, eine Abstandsbestimmung durchgeführt. Auch ist die Abstandsbestimmung mittels des erfindungsgemäßen Verfahrens recht genau, da Meßfehler aufgrund von Beugungseffekten, die bei optischen Verfahren aufgrund der Struktur der zu untersuchenden Probe auftreten können, nicht auftreten. Insbesondere werden auch Abbe-Fehler vermieden, da das Verfahren sich direkt auf die Strahlachse des Primärteilchenstrahls bzw. des Sekundärteilchenstrahls bezieht.

Das erfindungsgemäße Verfahren gewährleistet auch, daß eine nicht gewollte Verkippung einer zu untersuchenden Probe, die auf einem Probenträger angeordnet ist, schnell erkannt wird, so daß entsprechende Gegenmaßnahmen eingeleitet werden können. Hierzu wird die Probe in X-Y-Richtung (also in der Ebene senkrecht zur Strahlachse eines Teilchenstrahlgeräts) verschoben und dabei mehrmals der Abstand bestimmt. Durch Vergleich der gemessenen Abstände ist eine Verkippung der Probe schnell ermittelbar. Anschließend kann beispielsweise durch geeignete Einstellung des Probenträgers der Verkippung entgegengewirkt werden. Alternativ kann auch die Verkippung mittels Algorithmen bei der Auswertung der gemessenen Signale herausgerechnet werden.

Das erfindungsgemäße Verfahren eignet sich auch zur Bestimmung der Topographie einer Probe. Denn durch die Bestimmung des Abstandes läßt sich auf einfache Weise eine Struktur der Oberfläche der Probe bestimmen.

Alternativ zum Aufmodulieren eines Signals auf das erste Potential der Probe ist es auch möglich, weitere Potentiale zu variieren, beispielsweise das Hochspannungspotential, das zur Erzeugung des Primärteilchenstrahls in einem Elektronenstrahlgerät verwendet wird. Auch können die Potentiale von Bauelementen, die entlang der Strahlachse eines Elektronenstrahlgerätes angeordnet sind, moduliert werden. Wesentlich ist nur, daß zwischen dem Ort des Detektors und der Modulation eines Potentials eine Beziehung besteht, aus der der Abstand ermittelt wird.

Bei einer besonderen Ausführungsform des erfindungsgemäßen Verfahrens wird dem ersten Potential der Probe ein Signal mit einer vorgegebenen Frequenz aufmoduliert. Besonders geeignet ist ein sinusförmiges Signal. Es ist dabei vorgesehen, daß die Frequenz des aufmodulierten Signals wählbar und somit einstellbar ist. Mittels der einstellbaren Frequenz kann die Auflösung des Verfahrens bestimmt werden, worauf weiter unten noch näher eingegangen wird. Bei einer besonderen Ausführungsform des erfindungsgemäßen Verfahrens wird dem ersten Potential der Probe ein Signal mit einer Frequenz zwischen 10 MHz und 100 GHz aufmoduliert.

Der Abstand der Probe von dem Referenzpunkt wird vorzugsweise mittels einer Phasendifferenz zwischen dem detektierten aufmodulierten Signal und dem Referenzsignal bestimmt. Dabei ergibt sich der Abstand durch die folgende Gleichung (Gleichung 1):

$$Z = \left( \frac{\Delta\varphi}{\pi} + \varphi_{offset} \right) \times \frac{V_{Teilchen}}{2 \times f_{mod}}$$

wobei Z der Abstand der Probe von dem Referenzpunkt, $\Delta\varphi$ die Phasendifferenz zwischen einer ersten Phasenkonstante des detektierten aufmodulierten Signals und einer zweiten Phasenkonstante des Referenzsignals, $\varphi_{offset}$ eine zur Bestimmung des Abstandes Z wesentliche Parameter umfassende Größe, $V_{Teilchen}$ die Geschwindigkeit der Teilchen des Sekundärteilchenstrahls und $f_{mod}$ die Frequenz des aufmodulierten Signals ist.

Nachfolgend wird auf die Herleitung und einzelne Größen der Gleichung 1 eingegangen. Die Laufzeit der Teilchen des Sekundärteilchenstrahls von der Probe bis zu einem sich am Referenzpunkt befindlichen Detektor ist durch

$$t = \frac{Z}{V_{Teilchen}}$$

gegeben, wobei t die Laufzeit, Z der Abstand zwischen der Probe und dem Detektor sowie $V_{Teilchen}$ die Geschwindigkeit der Teilchen des Sekundärteilchenstrahls ist. Die Phasenverschiebung zwischen dem Ort der Probe und dem Referenzpunkt bzw. dem Detektor ergibt sich durch die Gleichung (Gleichung 2)

$$\Delta\varphi = 2 \times \pi \times f_{mod} \times t = \frac{2 \times \pi \times f_{mod} \times Z}{V_{Teilchen}}$$

Zur Bestimmung des Abstandes (absolute Entfernung) müssen allerdings weitere Effekte berücksichtigt werden, beispielsweise eine Nachbeschleunigung der Teilchen des Sekundärteilchenstrahls vor dem Detektor, mögliche Änderungen des Bahnverlaufs der Teilchen sowie mögliche Phasenoffsets aufgrund von Verstärkern oder Filtern, die in einem Teilchenstrahlgerät, insbesondere einem Elektronenstrahlgerät verwendet werden. Diese Parameter werden in einem Phasenoffset $\varphi_{offset}$ berücksichtigt. Durch Umstellung der Gleichung 2 und Berücksichtigung des Phasenoffets $\varphi_{offset}$ erhält man die Gleichung 1.

Wie oben erwähnt, werden für die Bestimmung des Abstandes vorzugsweise Rückstreuelektronen verwendet, die nach Austritt aus der Probe eine Energieverteilung mit einem Maximum aufweisen, das nahe an der Anregungsenergie der Teilchen des Primärteilchenstrahls liegt. Die Berechnung der Geschwindigkeit der Rückstreuelektronen erfolgt bei hohen Beschleunigungsspannungen der Teilchen des Primärteilchenstrahls relativistisch.

Da Phasensprünge nicht erkannt werden, ist für $\Delta\varphi \leq \pi$ eine eindeutige Absolutmessung des Abstandes möglich. Dies führt zu einem maximalen Abstand der Probe von dem Referenzpunkt (Detektor), der nicht überschritten werden darf. Der maximale Abstand wird durch zwei Größen, nämlich die bereits oben genannte Frequenz des aufmodulierten Signals (Modulationsfrequenz) sowie die Geschwindigkeit der Teilchen des Sekundärelektronenstrahls, bestimmt. Mit $\Delta\varphi = \pi$ ergibt sich durch Umstellung von Gleichung 2 (Gleichung 3):

$$Z_{MAX} = \frac{V_{Teilchen}}{2 \times f_{mod}}$$

wobei $Z_{MAX}$ den maximalen Abstand der Probe vom Referenzpunkt (Detektor), $V_{Teilchen}$ die Geschwindigkeit der Teilchen des Sekundärteilchenstrahls und $f_{mod}$ die Frequenz des aufmodulierten Signals bezeichnen. Wie sofort ersichtlich ist, kann durch Variation der Geschwindigkeit und der Frequenz des aufmodulierten Signals der maximale Abstand der Probe zum Referenzpunkt und somit der Meßbereich eingestellt werden. Gegebenfalls kann auch hier $\varphi_{offset}$ berücksichtigt werden.

Vorzugsweise wird als Referenzsignal, mit dem das detektierte aufmodulierte Signal verglichen wird, das ursprünglich dem ersten Potential der Probe aufmodulierte Signal verwendet.

Des weiteren kann der Abstand bei dem erfindungsgemäßen Verfahren durch ein Heterodyningverfahren (Überlagerungsverfahren) bestimmt werden. Hierbei erfolgt eine Messung zeitlich nacheinander bei zwei leicht unterschiedlichen Modulationsfrequenzen. Durch die Bestimmung der Phasenwerte bei beiden Modulationsfrequenzen kann die Lage der Phase innerhalb eines vergrößerten Eindeutigkeitsbereichs eindeutig bestimmt werden, der durch die Differenzfrequenz beider Modulationsfrequenzen gegeben ist.

Neben den zuvor genannten Größen wird das Auflösungsvermögen des erfindungsgemäßen Verfahrens bei Bestimmung des Abstands mittels der Phasendifferenz auch durch die Auflösung der Phasenmessung bestimmt. Verfahren mit hoher Auflösung bei der Phasenmessung sind bereits bekannt, so daß hier nicht weiter darauf eingegangen wird.

Der Referenzpunkt des erfindungsgemäßen Verfahrens ist vorzugsweise durch die Position eines Teilchendetektors gegeben, mit dessen Hilfe die Teilchen des Sekundärteilchenstrahls detektiert sowie das aufmodulierte Signal bestimmt wird. Je nach Position des Teilchendetektors und somit je nach Entfernung des Teilchendetektors zur Probe können an unterschiedlichen Positionen unterschiedliche Signal-Rausch-Verhältnisse auftreten. Um hierdurch auftretende Meßungenauigkeiten zu vermeiden, ist es von Vorteil, zur Bestimmung des Abstands mehrere Teilchendetektoren zu verwenden, die an unterschiedlichen Positionen angeordnet sind. Es wird dann der Abstand jedes Teilchendetektors zur Probe bestimmt und mit Hilfe geeigneter Algorithmen der genaue Abstand der Probe zu einer Objektivlinse berechnet.

Von Vorteil ist auch, daß bei einem Ausführungsbeispiel des erfindungsgemäßen Verfahrens die Bestimmung des Abstands mittels einer Meßelektronik automatisch erfolgt. Wird das erfindungsgemäße Verfahren in einem Teilchenstrahlgerät, beispielsweise einem Rasterelektronenmikroskop eingesetzt, so wird nach dem Einführen einer Probe auf einen Probenträger in eine Probenkammer des Teilchenstrahlgeräts automatisch sofort der Abstand der Probe zu einem Detektor ermittelt. Wie oben erwähnt, ist dadurch auch der Abstand der Probe zu einer Objektivlinse ermittelbar, so daß anschließend der auf die Probe auftreffende Primärelektronenstrahl fokussiert werden kann. Ein Einstellen und Fokussieren von Hand entfällt.

Wie bereits erwähnt, ist das Verfahren in einem Teilchenstrahlgerät, insbesondere einem Rasterelektronenmikroskop, einsetzbar. Das erfindungsgemäße Verfahren eignet sich aber auch zur Abstandsbestimmung in einem Transmissionselektronenmikroskop oder einem Ionenstrahlgerät.

Eine erfindungsgemäße Vorrichtung zur Bestimmung des Abstands einer zu untersuchenden Probe von mindestens einem Referenzpunkt, insbesondere zur Durchführung des oben beschriebenen erfindungsgemäßen Verfahrens, weist mindestens eine Modulationseinheit zur Aufmodulierung eines Signals auf ein erstes Potential der Probe oder auf ein Hochspannungspotential auf. Ferner ist mindestens ein Strahlerzeuger zum Erzeugen eines Primärteilchenstrahls vorgesehen, der auf die Probe gelenkt wird. Beim Auftreffen des Primärteilchenstrahls auf die Probe wird ein aus Teilchen bestehender Sekundärteilchenstrahl erzeugt, der von der Probe weggeführt wird und dessen Teilchen eine Energie mit dem aufmodulierten Signal aufweisen. Die Vorrichtung weist ferner mindestens einen Detektor zur Detektion der Teilchen des Sekundärteilchenstrahls sowie des der Energie der Teilchen des Sekundärteilchenstrahls aufmodulierten Signals auf und ist darüber hinaus mit mindestens einer Auswertungseinheit zum Vergleichen des detektierten aufmodulierten Signals mit einem Referenzsignal versehen. Aus einer Relation zwischen dem Referenzsignal und dem detektierten aufmodulierten Signal wird der Abstand bestimmt.

Vorzugsweise ist die Modulationseinheit zur Aufmodulierung eines Signals mit einer vorgegebenen Frequenz ausgebildet, wobei diese Frequenz mittels der Modulationseinheit oder einer Einstelleinheit vorzugsweise einstellbar ist. Von Vorteil ist dabei die Aufmodulierung eines sinusförmigen Signals.

Bei einer weiteren Ausführungsform der erfindungsgemäßen Vorrichtung ist der Detektor über eine Signalverstärkungseinheit und einen Bandpaßfilter mit der Auswertungseinheit verbunden. Die Signalverstärkungseinheit dient der Verstärkung des durch den Detektor erzeugten Signals, hingegen dient der Bandpaßfilter der Aufbereitung des durch die Signalverstärkungseinheit erzeugten Signals. Das Vorgenannte ist aus dem Stand der Technik schon gut bekannt, so daß hierauf nicht näher eingegangen wird.

Um die Auswertung vorzunehmen, ist die Auswertungseinheit mit der Modulationseinheit verbunden, so daß die Auswertungseinheit sowohl das dem Potential der Probe aufmodulierte Signal als Referenzsignal und das detektierte aufmodulierte Signal erhält. Durch Bestimmung der Phasendifferenz zwischen dem detektierten aufmodulierten Signal und dem Referenzsignal ist dann der Abstand der Probe zum Detektor bestimmbar.

Die Anordnung des Detektors in der Vorrichtung kann geeignet gewählt werden. Bei einer Ausführungsform ist beispielsweise vorgesehen, daß der Detektor symmetrisch um eine Strahlachse verläuft, auf der der Primärteilchenstrahl geführt wird. Bei dieser Ausführungsform ist der Detektor beispielsweise als Konversionselektrode ausgebildet. Bei Auftreffen des Sekundärteilchenstrahls auf diesen Detektor werden Sekundärelektronen ausgelöst, die zu einem Absaugdetektor abgesaugt und dort detektiert werden. Alternativ hierzu ist der Detektor auch als Kombination eines Szintillators mit einem Photomultiplier ausgebildet.

Alternativ oder zusätzlich zu der symmetrischen Anordnung ist der Detektor außeraxial zur Strahlachse angeordnet, auf der der Primärteilchenstrahl geführt wird.

Von Vorteil ist auch, wenn die Vorrichtung gemäß der Erfindung mehrere Detektoren an unterschiedlichen Positionen aufweist, wie oben bereits hinsichtlich des erfindungsmäßen Verfahrens erläutert.

Wie ebenfalls bereits oben erwähnt, ist das erfindungsgemäße Verfahren insbesondere zum Einsatz in einem Teilchenstrahlgerät, insbesondere in einem Elektronenstrahlgerät, geeignet. Das Teilchenstrahlgerät weist die oben beschriebene erfindungsgemäße Vorrichtung auf. Zudem ist es mit einer Objektivlinse zur Fokussierung des Primärteilchenstrahls auf der Probe versehen, wobei die Objektivlinse eine zum Strahlerzeuger gerichtete erste Seite und eine zur Probe gerichtete zweite Seite aufweist. Der Detektor ist dabei auf der ersten Seite der Objektivlinse angeordnet. Die Erfindung ist insbesondere für Teilchenstrahlgeräte geeignet, die mittels mindestens eines Rastermittels den Primärteilchenstrahl über die Probe rastern können. Vorzugsweise ist das Teilchenstrahlgerät als Rasterelektronenmikroskop oder als Transmissionselektronenmikroskop ausgebildet. Die Erfindung ist aber nicht auf derartige Teilchenstrahlgeräte eingeschränkt. Vielmehr ist die Erfindung für jedes Teilchenstrahlgerät geeignet, bei dem eine Abstandsmessung vorgenommen werden muß.

Nachfolgend wird die Erfindung anhand eines Ausführungsbeispiels näher erläutert. Es zeigt

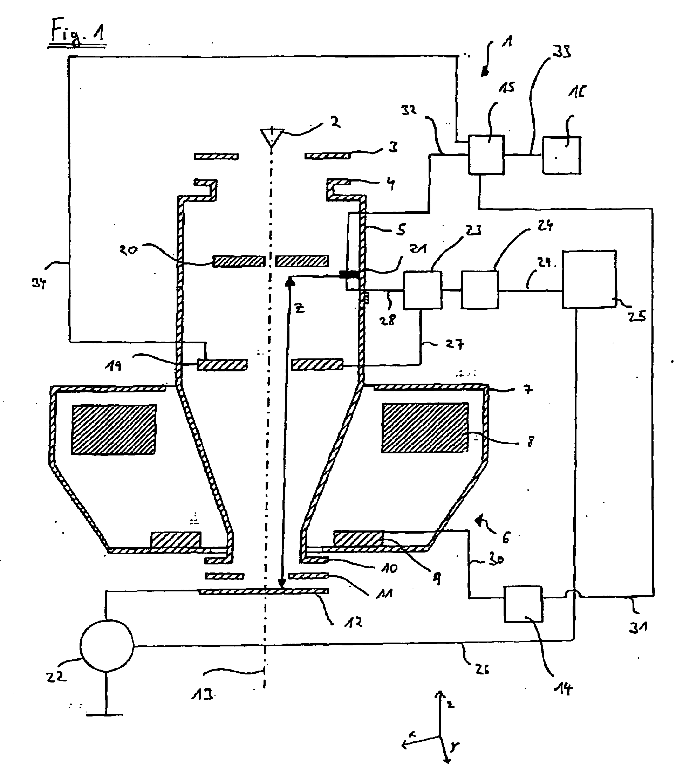

Fig. 1 eine schematische Darstellung eines Teilchenstrahlgeräts mit einer Vorrichtung zur Bestimmung des Abstands einer Probe zu einem Detektor.

Die Erfindung wird nachfolgend beispielhaft anhand eines Rasterelektronenmikroskops beschrieben. Sie ist aber nicht auf Rasterelektronenmikroskope eingeschränkt, sondern eignet sich für jedes Teilchenstrahlgerät.

Fig. 1 zeigt die schematische Darstellung eines Teilchenstrahlgeräts in Form eines Rasterelektronenmikroskops 1. Das Rasterelektronenmikroskop 1 weist einen Strahlerzeuger in Form einer Elektronenquelle 2 (Kathode), eine Extraktionselektrode 3 sowie eine Anode 4 auf, die gleichzeitig ein Ende eines Strahlführungsrohres 5 des Rasterelektronenmikroskops 1 bildet. Vorzugsweise ist die Elektronenquelle 2 ein thermischer Feldemitter. Elektronen, die aus der Elektronenquelle 2 austreten, werden aufgrund einer Potentialdifferenz zwischen der Elektronenquelle 2 und der Anode 4 auf Anodenpotential beschleunigt und bilden einen Primärelektronenstrahl.

Das Rasterelektronenmikroskop 1 ist mit einer Objektivlinse 6 versehen, die Polschuhe 7 aufweist, in denen eine Bohrung eingelassen ist. In der Bohrung ist das Strahlführungsrohr 5 geführt. In den Polschuhen 7 sind Spulen 8 angeordnet, wie sie bereits seit langem bekannt sind. Hinter das Strahlführungsrohr 5 ist eine elektrostatische Verzögerungseinrichtung geschaltet. Diese besteht aus einer Einzelelektrode 11 und einer Rohrelektrode 10, die an dem einer Probe 12 gegenüberliegenden Ende des Strahlführungsrohres 5 ausgebildet ist. Somit liegt die Rohrelektrode 10 gemeinsam mit dem Strahlführungsrohr 5 auf Anodenpotential, während die Einzelelektrode 11 sowie die Probe 12 auf einem gegenüber dem Anodenpotential niedrigeren Potential liegen. Auf diese Weise können die Elektronen des Primärelektronenstrahls auf eine gewünschte niedrige Energie abgebremst werden, die für die Untersuchung der Probe 12 erforderlich ist. Ferner sind Rastermittel 9 vorgesehen, durch die der Primärelektronenstrahl abgelenkt und über die Probe 12 gerastert werden kann.

Zur Detektion von Sekundärelektronen oder Rückstreuelektronen, die aufgrund der Wechselwirkung des Primärelektronenstrahls mit der Probe 12 von der Probe 12 emittiert bzw. zurückgestreut werden, ist eine Detektoranordnung im Strahlführungsrohr 5 angeordnet, die Detektoren 19, 20 und 21 aufweist. Der Detektor 19 ist dabei symmetrisch um die Strahlachse 13 im Strahlführungsrohr 5 etwas oberhalb der Objektivlinse 6 angeordnet. Der Detektor 19 ist dabei in bekannter Weise als Szintillator mit einem Glaslichtleiter und einem dahintergeschalteten Photomultiplier ausgebildet.

Ferner ist eine in Richtung des Strahlerzeugers 2 angeordnete und zu dem Detektor 19 beabstandete, als Detektor 20 ausgebildete Konversionselektrode vorgesehen. Der Detektor 20 löst beim Auftreffen der von der Probe emittierten bzw. zurückgestreuten Elektronen wiederum selbst Sekundärelektronen aus, die zu dem Detektor 21 gesaugt und dort im Detektor 21 detektiert werden. Die Absaugung und die Beschleunigung der Sekundärelektronen vom Detektor 20 zum Detektor 21 sind seit langem bekannt und werden hier nicht weiter beschrieben.

Zur Bildgebung sind die Rastermittel 9 über eine Leitung 30 mit einem Rastergenerator 14 verbunden, der wiederum über eine Leitung 31 mit einer Bilderzeugungs- bzw. Bildspeichereinheit 15 verbunden ist. Die Bilderzeugungs- bzw. Bildspeichereinheit 15 erhält von den Detektoren 21 und 19 über Leitungen 32 bzw. 34 Detektorsignale, die zur Bildgebung verwendet werden. Entsprechende Bildsignale werden über eine Leitung 33 von der Bilderzeugungs- bzw. Bildspeichereinheit 15 an einen Monitor 16 weitergegeben.

Die Probe 12 ist auf einem Objektträger (nicht dargestellt) angeordnet, der in X-Richtung, Y-Richtung und Z-Richtung beweglich ist. Insbesondere ist der Objektträger auch kippbar. Der Abstand Z der Probe 12 zu den Detektoren 19 und 21 (wobei in Fig. 1 aus Gründen der Übersichtlichkeit nur der Abstand Z der Probe 12 zu dem Detektor 21 eingezeichnet ist) wird mittels der nachstehend beschriebenen Vorrichtung ermittelt.

Die Probe 12 ist mit einer Modulationseinheit 22 verbunden, welche wiederum über eine Leitung 26 mit einer Auswertungseinheit 25 verbunden ist. Diese Auswertungseinheit 25 erhält über eine Signalverstärkungseinheit 23 und einen Bandpaßfilter 24 die durch die Detektoren 19 und 21 detektierten Signale. Zur Verbindung der einzelnen Einheiten sind Leitungen 27, 28 und 29 vorgesehen.

Mittels der Modulationseinheit 22 wird dem Potential der Probe 12 ein sinusförmiges Signal aufmoduliert. Dieses aufmodulierte Signal wird praktisch auf die von der Probe 12 zurückgestreuten Elektronen (Rückstreuelektronen) "übertragen". In den Detektoren 19 bzw. 21 werden zur Abstandsbestimmung hauptsächlich die Rückstreuelektronen detektiert und somit auch das aufmodulierte sinusförmige Signal. Aufgrund der Entfernung der Probe 12 zu den Detektoren 19 und 21 ist das detektierte aufmodulierte Signal allerdings zu dem ursprünglich aufmodulierten Signal phasenverschoben. Die Phasenverschiebung wird in der Auswertungseinheit 25 bestimmt. Die Entfernung Z der Probe 12 zum Detektor 21 bzw. zum Detektor 19 wird dabei mittels der Gleichung bestimmt

$$Z = \left( \frac{\Delta\varphi}{\pi} + \varphi_{offset} \right) \times \frac{V_{Teilchen}}{2 \times f_{mod}}$$

wobei Z der Abstand der Probe 12 von dem Detektor 19 bzw. 21 sowie $\Delta\varphi$ die Phasendifferenz zwischen dem am Ort der Probe 12 aufmodulierten Signal und dem am Ort des Detektors 19 bzw. 21 ermittelten Signal ist. Die weiteren Größen wurden bereits weiter oben erläutert.

Durch das beschriebene Verfahren sowie die beschriebene Vorrichtung ist es auf einfache Weise möglich, den Abstand der Probe 12 zu dem Detektor 19 und 21 genau zu bestimmen. Da in dem Rasterelektronenmikroskop 1 die Position der Detektoren 19 und 21 gegenüber der Objektivlinse 6 festgelegt ist, ist auf diese Weise auch der Abstand zwischen der Probe 12 und der Objektivlinse 6 genau bestimmbar und somit auch einstellbar. Auf diese Weise ist es einfach möglich, den Primärteilchenstrahl auf der Probe 12 ausreichend zu fokussieren.

Gegenüber dem Stand der Technik weist das beschriebene Verfahren und die beschriebene Vorrichtung den Vorteil auf, daß kein zusätzliches System zur Abstandsbestimmung benötigt wird. Vielmehr wird der Abstand mittels des Primärelektronenstrahls und sowie hauptsächlich mittels der von der Probe 12 zurückgestreuten Elektronen aufgrund einer Phasendifferenzmessung ermittelt. Das beschriebene Verfahren ist daher unabhängig insbesondere von optischen Eigenschaften der zu untersuchenden Probe 12.

Es wird nochmals ausdrücklich darauf hingewiesen, daß die Erfindung nicht auf Rasterelektronenmikroskope eingeschränkt ist. Vielmehr ist die Erfindung bei jedem Teilchenstrahlgerät einsetzbar, insbesondere auch bei einem Transmissionselektronenmikroskop, das in einem Spotmodus (fokussierter Elektronenstrahl) betrieben wird.

**Bezugszeichenliste**

| 1 | Rasterelektronenmikroskop |
|---|---|
| 2 | Elektronenquelle |
| 3 | Extraktionselektrode |
| 4 | Anode |
| 5 | Strahlführungsrohr |
| 6 | Objektivlinse |
| 7 | Polschuh |
| 8 | Spule |
| 9 | Rastermittel |
| 10 | Rohrelektrode |
| 11 | Elektrode |
| 12 | Probe |
| 13 | Strahlachse |
| 14 | Rastergenerator |
| 15 | Bilderzeugungs- bzw. Bildspeichereinheit |
| 16 | Monitor |
| 19 | Detektor |
| 20 | Konversionselektrode |
| 21 | Detektor |
| 22 | Modulationseinheit |
| 23 | Signalverstärkungseinheit |
| 24 | Bandpaßfilter |
| 25 | Auswertungseinheit |
| 26 | Leitung |
| 27 | Leitung |
| 28 | Leitung |
| 29 | Leitung |
| 30 | Leitung |
| 31 | Leitung |
| 32 | Leitung |
| 33 | Leitung |
| 34 | Leitung |

**Patentansprüche**

1. Verfahren zur Bestimmung des Abstands (Z) einer zu untersuchenden Probe (12) von mindestens einem Referenzpunkt (19, 21), mit den folgenden Schritten:

- Aufmodulieren eines Signals auf ein erstes Potential der Probe (12) oder auf ein Hochspannungspotential zur Erzeugung eines Primärteilchenstrahls oder auf Potentiale von Bauelementen entlang der Strahlachse eines Elektronenstrahlgerätes;
- Zuführen eines Pirimärteilchenstrahls auf die Probe (12), wobei bei einem Auftreffen des Primärteilchenstrahls auf die Probe (12) ein aus Teilchen bestehender Sekundärteilchenstrahl erzeugt wird, der von der Probe weggeführt wird und dessen Teilchen am Orf eines Detektors eine Energiedifferenz mit dem aufmodulierten Signal aufweisen;
- Detektion der Teilchen des Sekundärteilchenstrahls sowie des der Energiedifferenz der Teilchen des Sekundärteilchenstrahls aufmodulierten Signals; sowie
- Vergleichen des detektierten aufmodulierten Signals mit einem Referenzsignal, wobei aus einer Relation zwischen dem Referenzsignal und dem detektierten aufmodulierten Signal der Abstand (Z) bestimmt wird.

2. Verfahren nach Anspruch 1, bei dem die Teilchen des Sekundärteilchenstrahls Rückstreuelektronen sind.

3. Verfahren nach Anspruch 1 oder 2, bei dem das Signal, das auf das erstes Potential der Probe aufmoduliert wird, eine vorgegebene Frequenz auf weist, insbesondere als sinusförmiges Signal gebildet ist und wobei die Frequenz vorzugsweise wählbar ist.

4. Verfahren nach einem der vorhergehenden Ansprüche, bei dem das Signal mit einer Frequenz zwischen 10 MHz und 100 GHz aufmoduliert wird.

5. Verfahren nach einem der vorhergehenden Ansprüche, bei dem der Abstand (Z) der Probe (12) von dem Referenzpunkt (19, 21) aufgrund einer Phasendifferenz zwischen dem detektierten aufmodulierten Signal und dem Referenzsignal mittels der folgenden Gleichung ermittelt wird:

$$Z = \left( \frac{\Delta\varphi}{\pi} + \varphi_{offset} \right) \times \frac{V_{Teilchen}}{2 \times f_{mod}}$$

wobei Z der Abstand der Probe (12) von dem Referenzpunkt (19, 21), $\Delta\varphi$ die Phasendifferenz zwischen einer ersten Phasenkonstanten des detektierten aufmodulierten Signals und einer zweiten Phasenkonstanten des Referenzsignals, $\varphi_{offest}$ eine zur Bestimmung des Abstandes (Z) wesentliche Parameter umfassende Größe, $V_{Teilchen}$ die Geschwindigkeit der Teilchen des Sekundärteilchenstrahls und $f_{mod}$ die Frequenz des aufmodulierten Signals ist.

6. Verfahren nach einem der vorhergehenden Ansprüche, wobei das Verfahren einen Meßbereich aufweist, der durch einen maximalen Abstand begrenzt ist, den die Probe (12) zu dem Referenzpunkt (19, 21) aufweisen darf, wobei der maximale Abstand durch die folgende Gleichung gegeben ist:

$$Z_{MAX} = \frac{V_{Teilchen}}{2 \times f_{mod}}$$

wobei $Z_{MAX}$ den maximalen Abstand der Probe (12) vom Referenzpunkt (19, 21), $V_{Teileben}$ die Geschwindigkeit der Teilchen des Sekundärteilchenstrahls und $f_{mod}$ die Frequenz des aufmodulierten Signals darstellt.

7. Verfahren nach einem der vorhergehenden Ansprüche, bei dem als Referenzsignal das dem ersten Potential der Probe aufmodulierte Signal verwendet wird.

8. Verfahren nach einem der vorhergehenden Ansprüche, bei dem der Referenzpunkt durch die Position eines Detektors (19, 21) zur Detektion der Teilchen gegeben ist.

9. Verfahren nach einem der vorhergehenden Ansprüche, bei dem die Bestimmung des Abstands (Z) mittels einer Meßelektronik (25) automatisch erfolgt.

10. Verfahren nach einem der vorhergehenden Ansprüche, bei dem der Abstand (Z) der Probe (12) von dem Referenzpunkt (19, 21) in einem Teilchenstrahlgerät (1), insbesondere einem Elektronenmikroskop, bestimmt wird.

11. Vorrichtung zur Bestimmung des Abstands (Z) einer zu untersuchenden Probe (12) von mindestens einem Referenzpunkt (19, 21), insbesondere zur Durchführung eines Verfahrens nach einem der Ansprüche 1 bis 10,
mit

    - mindestens einer Modulationseinheit (22) zur Aufmodulierung eines Signals auf ein erstes Potential der Probe (12) oder auf ein Hochspannungspotential zur Erzeugung eines Primärteilchenstrahls oder auf Potentiale von Bauelementen entlang der Strahlachse eines Elektromenstrahlgerätes;
    - mindestens einem Strahlerzeuger (2) zum Erzeugen eines Primärteilchenstrahls, der auf die Probe (12) auftrifft, wobei bei einem Auftreffen des Primärteilchenstrahls auf die Probe (12) ein aus Teilchen bestehender Sekundärteilchenstrahl erzeugt wird, der von der Probe (12) weggeführt wird und dessen Teilchen am Orf eines Detektors mit dem aufmodulierten Signal aufweisen;
    - mindestens einem Detektor (19, 20, 21) zur Detektion der Teilchen des Sekundärteilchenstrahls sowie zur Detektion des der Energiedifferenz der Teilchen des Sekundärteilchenstrahls aufmodulierten Signals; sowie mit
    - mindestes einer Auswertungseinheit (25) zum Vergleichen des detektierten aufmodulierten Signals mit einem Referenzsignal, wobei aus einer Relation zwischen dem Referenzsignal und dem detektierten aufmodulierten Signal der Abstand (Z) bestimmt wird.

12. Vorrichtung nach Anspruch 11, wobei die Modulationseinheit (22) zur Aufmodulierung des Signales mit einer vorgegebenen Frequenz ausgebildet ist, insbesondere zur Aufmodulierung eines sinusförmigen Signals.

13. Vorrichtung nach Anspruch 11 oder 12, wobei der Detektor (19, 21) über einen Signalverstärker (23) und einen Bandpaßfilter (24) mit der Auswertungseinheit (25) verbunden ist.

**14.** Vorrichtung nach einem der Ansprüche 11 bis 13, wobei die Modulationseinheit (22) zur Bereitstellung des Referenzsignals mit der Auswertungseinheit (25) verbunden ist.

**15.** Vorrichtung nach einem der Ansprüche 11 bis 14, wobei der Detektor (19, 20) symmetrisch um eine Strahlachse (13) verläuft, auf der der Primärteilchenstrahl geführt wird.

**16.** Vorrichtung nach einem der Ansprüche 11 bis 15, wobei der Detektor (21) außeraxial zur Strahlachse (13) angeordnet ist, auf der der Primärteilchenstrahl geführt wird.

**17.** Verwendung des Verfahrens nach einem der Ansprüche 1 bis 10 und/oder der Vorrichtung nach einem der Ansprüche 11 bis 16 zur Bestimmung der Topographie einer zu untersuchenden Probe (12).

**18.** Teilchenstrahlgerät (1), insbesondere ein Elektronenstrahlgerät, mit einer Vorrichtung nach einem der Ansprüche 11 bis 16 sowie mit einer Objektivlinse (6) zur Fokussierung des Primärteilchenstrahls auf die Probe (12), wobei die Objektivlinse (6) eine zum Strahlerzeuger (2) gerichtete erste Seite und eine zur Probe (12) gerichtete zweite Seite aufweist, und wobei der Detektor (19, 20 , 21) auf der ersten Seite der Objektivlinse (6) angeordnet ist.

**19.** Teilchenstrahlgerät nach Anspruch 18, wobei der Detektor (19, 20, 21) zur Bildgebung ausgebildet ist.

**20.** Teilchenstrahlgerät (1) nach Anspruch 18 oder 19, wobei das Teilchenstrahlgerät (1) mindestens ein Rastermittel (9) zur Rasterung des Primärteilchenstrahls über die Probe (12) aufweist.

**21.** Teilchenstrahlergerät (1) nach einem der Ansprüche 18 bis 20, wobei das Teilchenstrahlgerät (1) als Rasterelektronenmikroskop ausgebildet ist.

**22.** Teilchenstrahlgerät nach nach einem der Ansprüche 18 bis 20, wobei das Teilchenstrahlgerät als Transmissionselektronenmikroskop ausgebildet ist.

**Claims**

**1.** Method for determining the distance (Z) from a sample (12) to be examined to at least one reference point (19, 21), comprising the following steps:

- modulating a signal to a first potential of the sample (12) or to a high voltage potential for generating a primary particle beam or to potentials of components situated along the beam axis of an electron beam device;
- directing a primary particle beam at the sample (12), a secondary particle beam composed of particles being generated when the primary particle beam strikes the sample (12) and being directed away from the sample, and whose particles have an energy difference with the modulated signal at the location of the detector ;
- detecting the particles of the secondary particle beam and the signal modulated to the energy difference of the particles of the secondary particle beam, and
- comparing the detected modulated signal with a reference signal, the distance (Z) being determined from a relationship between the reference signal and the detected modulated signal.

**2.** Method according to claim 1, wherein the particles of the secondary particle beam are backscattered electrons.

**3.** Method according to claim 1 or 2, wherein the signal that is modulated to the first potential of the sample has a predefined frequency, in particular being formed as a sine signal, and the frequency preferably being selectable.

**4.** Method according to one of the preceding claims, wherein the signal is modulated with a frequency between 10 MHz and 100 GHz.

**5.** Method according to one of the preceding claims, wherein the distance (Z) of the sample (12) from the reference point (19, 21) is ascertained on the basis of a phase difference between the detected modulated signal and the reference signal using the following equation:

$$Z = \left( \frac{\Delta\varphi}{\pi} + \varphi_{\text{offset}} \right) \times \frac{V_{\text{particles}}}{2 \times f_{\text{mod}}}$$

where Z is the distance from the sample (12) to the reference point (19, 21), $\Delta\varphi$ is the phase difference between a first phase constant of the detected modulated signal and a second phase constant of the reference signal, $\varphi_{\text{offset}}$ is a quantity that includes essential parameters for determining the distance (Z), $V_{\text{particles}}$ is the velocity of the particles of the secondary particle beam and $f_{\text{mod}}$ is the frequency of the modulated signal.

**6.** Method according to one of the preceding claims, wherein the method has a measuring range that is limited by the maximum distance allowed between the sample (12) and the reference point (19, 21), the maximum distance being defined by the following equation:

$$Z_{MAX} = \frac{V_{particles}}{2 \times f_{mod}}$$

where $Z_{MAX}$ denotes the maximum distance from the sample (12) to the reference point (19, 21), $V_{Particles}$ is the velocity of the particles of the secondary particle beam and $f_{mod}$ is the frequency of the modulated signal.

7. Method according to one of the preceding claims, wherein the signal modulated to the first potential of the sample is used as the reference signal.

8. Method according to one of the preceding claims, wherein the reference point is defined by the position of a detector (19, 21) for detecting the particles.

9. Method according to one of the preceding claims, wherein the distance (Z) is determined automatically by an electronic measuring equipment (25).

10. Method according to one of the preceding claims, wherein the distance (Z) of the sample (12) from the reference point (19, 21) in a particle beam device (1), in particular an electron microscope, is determined.

11. Device for determining the distance (Z) of a sample (12) to be examined from at least one reference point (19, 21), in particular for performing a method according to one of claims 1 through 10, comprising

    - at least one modulation unit (22) for modulating a signal to a first potential of the sample (12)) or to a high voltage potential for generating a primary particle beam or to potentials of components situated along the beam axis of an electron beam device;
    - at least one electron gun (2) for generating a primary particle beam that strikes the sample (12), a secondary particle beam composed of particles being generated when the primary particle beam strikes the sample (12) and being directed away from the sample (12), and whose particles have an energy difference with the modulated signal at the location of the detector;
    - at least one detector (19, 20, 21) for detecting the particles of the secondary particle beam and for detection of the signal modulated to the energy difference of the particles of the secondary particle beam; and comprising
    - at least one analyzer unit (25) for comparing the detected modulated signal to a reference signal, the distance (Z) being determined from a relationship between the reference signal and the detected modulated signal.

12. Device according to claim 11, wherein the modulation unit (22) is designed for modulating the signal with a predefined frequency, in particular for modulating a sine signal.

13. Device according to claim 11 or 12, wherein the detector (19, 21) is connected to the analyzer unit (25) via a signal amplifier (23) and a bandpass filter (24).

14. Device according to one of claims 11 through 13, wherein the modulation unit (22) is connected to the analyzer unit (25) for providing the reference signal.

15. Device according to one of claims 11 through 14, wherein the detector (19, 20) runs symmetrically about a beam axis (13) on which the primary particle beam is guided.

16. Device according to one of claims 11 through 15, wherein the detector (21) is situated extra-axially with respect to the beam axis (13) on which the primary particle beam is guided.

17. Use of the method according to one of claims 1 through 10 and/or the device according to one of claims 11 through 16 for determining the topography of a sample (12) to be examined.

18. Particle beam device (1), in particular an electron beam device, having a device according to one of claims 11 through 16 and having an objective lens (6) for focusing the primary particle beam on the sample (12), wherein the objective lens (6) has a first side directed toward the electron gun (2) and a second side directed toward the sample (12) and wherein the detector (19, 20, 21) is situated on the first side of the objective lens (6).

19. Particle beam device according to claim 18, wherein the detector (19, 20, 21) is designed for imaging.

20. Particle beam device (1) according to claim 18 or 19, wherein the particle beam device (1) has at least one scanning means (9) for scanning the primary particle beam over the sample (12).

21. Particle beam device (1) according to one of claims 18 through 20, wherein the particle beam device (1) is designed as a scanning electron microscope.

22. Particle beam device according to one of claims 18 through 20, wherein the particle beam device is designed as a transmission electron microscope.

## Revendications

1. Procédé de détermination de l'écart (Z) d'un échantillon (12) devant être examiné par rapport à au moins un point de référence (19, 21), comprenant les étapes suivantes consistant à :

   - moduler un signal sur un premier potentiel de l'échantillon (12) ou sur un potentiel haute tension pour générer un faisceau de particules primaire ou sur des potentiels de composants le long de l'axe de faisceau d'un appareil à faisceau d'électrons ;
   - amener un faisceau de particules primaire sur l'échantillon (12), un faisceau de particules secondaire constitué de particules étant produit lors d'un impact du faisceau de particules primaire sur échantillon (12), ledit faisceau de particules secondaire s'éloignant de l'échantillon et ses particules présentant au niveau de l'emplacement d'un détecteur une différence d'énergie avec le signal modulé ;
   - détecter des particules du faisceau de particules secondaire, ainsi que du signal modulé sur la différence d'énergie des particules du faisceau de particules secondaire ; ainsi que
   - comparer le signal modulé détecté avec un signal de référence, l'écart (Z) étant déterminé à partir d'une relation existante entre le signal de référence et le signal modulé détecté.

2. Procédé selon la revendication 1, dans lequel les particules du faisceau de particules secondaire sont des électrons rétrodiffusés.

3. Procédé selon la revendication 1 ou 2, dans lequel le signal qui est modulé sur le premier potentiel de l'échantillon présente une fréquence spécifiée, en particulier est formé en tant que signal sinusoïdal, et la fréquence pouvant de préférence être choisie.

4. Procédé selon l'une quelconque des revendications précédentes, dans lequel le signal est modulé avec une fréquence comprise entre 10 MHz et 100 GHz.

5. Procédé selon l'une quelconque des revendications précédentes, dans lequel l'écart (Z) de l'échantillon (12) par rapport au point de référence (19, 21) est déterminé au moyen de l'équation suivante en se basant sur une différence de phase entre le signal modulé détecté et le signal de référence :

$$Z = \left( \frac{\Delta\varphi}{\pi} + \varphi_{\text{décalage}} \right) \times \frac{V_{\text{particules}}}{2 \times f_{\text{mod}}}$$

Z est l'écart de l'échantillon (12) par rapport au point de référence (19, 21), $\Delta_\varphi$ est la différence de phase entre une première constante de phase du signal modulé détecté et une seconde constante de phase du signal de référence, $\varphi_{\text{décalage}}$ est une valeur comprenant des paramètres essentiels pour une détermination de l'écart (Z), $V_{\text{particules}}$ est la vitesse des particules du faisceau de particules secondaire et $f_{\text{mod}}$ est la fréquence du signal modulé.

6. Procédé selon l'une quelconque des revendications précédentes, dans lequel le procédé présente une plage de mesure qui est limitée par un écart maximal que l'échantillon (12) doit présenter par rapport au point de référence (19, 21), l'écart maximal étant donné par l'équation suivante :

$$Z_{\text{MAX}} = \frac{V_{\text{particules}}}{2 \times f_{\text{mod}}}$$

$Z_{\text{MAX}}$ représentant l'écart maximal de l'échantillon (12) par rapport au point de référence (19, 21), $V_{\text{particules}}$ représentant la vitesse des particules du faisceau de particules secondaire et $f_{\text{mod}}$ représentant la fréquence du signal modulé.

7. Procédé selon l'une quelconque des revendications précédentes, dans lequel le signal modulé sur le premier potentiel de l'échantillon est utilisé en tant que signal de référence.

8. Procédé selon l'une quelconque des revendications précédentes, dans lequel le point de référence est donné par la position d'un détecteur (19, 21) destiné à détecter les particules.

9. Procédé selon l'une quelconque des revendications précédentes, dans lequel la détermination de l'écart (Z) a lieu de manière automatique au moyen d'une électronique de mesure (25).

10. Procédé selon l'une quelconque des revendications précédentes, dans lequel l'écart (Z) de l'échantillon (12) par rapport au point de référence (19, 21) est déterminé dans un appareil à faisceau de particules (1), en particulier un microscope électronique.

11. Dispositif de détermination de l'écart (Z) d'un échantillon (12) devant être examiné par rapport à au moins un point de référence (19, 21), en particulier pour une mise en oeuvre d'un procédé selon l'une quelconque des revendications 1 à 10, avec

   - au moins une unité de modulation (22) pour une modulation d'un signal sur un premier potentiel de l'échantillon (12) ou sur un potentiel haute tension pour créer un faisceau de particules primaire ou sur des potentiels de composants le long de l'axe de faisceau d'un appareil à faisceau d'électrons ;

- au moins un générateur de faisceau (2) destiné à générer un faisceau de particules primaire qui impacte l'échantillon (12), un faisceau de particules secondaire constitué de particules étant généré lors d'un impact du faisceau de particules primaire sur l'échantillon (12), ledit faisceau de particules secondaire s'éloignant de l'échantillon (12) et ses particules présentant au niveau de l'emplacement d'un détecteur une différence d'énergie avec le signal modulé ;

- au moins un détecteur (19, 20, 21) pour une détection des particules du faisceau de particules secondaire ainsi que pour une détection du signal modulé sur la différence d'énergie des particules du faisceau de particules secondaire ; ainsi qu'avec

- au moins une unité d'interprétation (25) pour une comparaison du signal modulé détecté avec un signal de référence, l'écart (Z) étant déterminé à partir d'une relation existante entre le signal de référence et le signal modulé détecté.

12. Dispositif selon la revendication 11, dans lequel l'unité de modulation (22) est réalisée pour une modulation du signal avec une fréquence spécifiée, en particulier pour une modulation d'un signal sinusoïdal.

13. Dispositif selon la revendication 11 ou 12, dans lequel le détecteur (19, 21) est relié à l'unité d'interprétation (25) par l'intermédiaire d'un amplificateur de signal (23) et d'un filtre passe-bande (24).

14. Dispositif selon l'une quelconque des revendications 11 à 13, dans lequel l'unité de modulation (22) est reliée à l'unité d'interprétation (25) pour fournir le signal de référence.

15. Dispositif selon l'une quelconque des revendications 11 à 14, dans lequel le détecteur (19, 20) s'étend de manière symétrique autour d'un axe de faisceau (13) sur lequel est guidé le faisceau de particules primaire.

16. Dispositif selon l'une quelconque des revendications 11 à 15, dans lequel le détecteur (21) est agencé de manière axiale externe par rapport à l'axe de faisceau (13), sur lequel le faisceau de particules primaire est guidé.

17. Utilisation du procédé selon l'une quelconque des revendications 1 à 10 et/ou du procédé selon l'une quelconque des revendications 11 à 16 pour une détermination de la topographie d'un échantillon (12) devant être examiné.

18. Appareil à faisceau de particules (1), en particulier un appareil à faisceau d'électrons, avec un dispositif selon l'une quelconque des revendications 11 à 16 ainsi qu'avec une lentille d'objectif (6) destinée à une focalisation du faisceau de particules primaire sur l'échantillon (12), la lentille d'objectif (6) présentant un premier côté dirigé vers le générateur de faisceau (2) et un second côté dirigé vers l'échantillon (12), et le détecteur (19, 20, 21) étant agencé sur le premier côté de la lentille d'objectif (6).

19. Appareil à faisceau de particules selon la revendication 18, dans lequel le détecteur (19, 20, 21) est réalisé en vue d'une formation d'image.

20. Appareil à faisceau de particules (1) selon la revendication 18 ou 19, dans lequel l'appareil à faisceau de particules (1) présente au moins un moyen de balayage (9) pour un balayage du faisceau de particules primaire sur l'échantillon (12).

21. Appareil à faisceau de particules (1) selon l'une quelconque des revendications 18 à 20, dans lequel l'appareil à faisceau de particules (1) est réalisé sous la forme d'un microscope électronique à balayage.

22. Appareil à faisceau de particules selon l'une quelconque des revendications 18 à 20, dans lequel l'appareil à faisceau de particules est réalisé sous la forme d'un microscope électronique à transmission.

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4978856 A
- US 5216235 A

- EP 1081741 A2